# EUROPEAN PATENT APPLICATION

(11) **EP 2 060 921 A1**
(43) Date of publication of application: **20.05.2009**
(21) Application number: 07425728.8
(22) Date of filing: 16.11.2007
(51) Int. Cl.: G01R 1/067, G01R 1/073, G01R 3/00

(54) **Contact probe for testing head having vertical probes and related testing head for testing microstructure electric performance**

(71) Applicant: Technoprobe S.p.A, 23870 Cernusco Lombardone (Lecco) (IT)
(72) Inventor: Crippa, Roberto, 23807 Merate (Lecco) (IT)
(74) Representative: Zambardino, Umberto

(57) **Abstract**

The invention describes a contact probe (16,16',16") for testing head having vertical probes for testing microstructure electric performance. Such a contact probe (16,16',16") comprises a body (20) extending essentially in the longitudinal direction formed in a first conductive material, which has a substantially central portion (17) and two opposite ends (7A,7B). The contact probe (16) is able to be held so that it can slide through the opposite ends (7A,7B) between corresponding guide holes (4,5) made in an upper guide (2) and in a lower guide (3) of the testing head. According to the invention, at least one of the ends (7A,7B) is at least partially coated with a layer (21A,21B;21C) of a second conductive material having a greater hardness than the first conductive material so as to improve the sliding of the at least one end (7A,7B) in the respective guide hole (5,4). The invention also describes a process for producing such a contact probe arid a testing head comprising such contact probes (16).

## Description

### Field of application

The present invention refers to a contact probe for testing head having vertical probes.

More specifically, the invention refers to a contact probe for testing head having vertical probes and related testing head for testing microstructure performance, in particular electric performance, said contact probe being slottable into a corresponding guide hole realized in an upper guide and in a lower guide of the testing head.

The invention also concerns a process for producing a contact probe of the aforementioned type.

The invention also refers to a testing head having vertical probes and related testing head for testing microstructure performance, in particular electric performance, comprising a plurality of guide holes corresponding to a plurality of contact probes, such guide holes being made in an upper guide and in a lower guide of such a testing head.

In particular, but not exclusively, the invention concerns a testing head having vertical probes of the type not fixedly connected and the following description is made with reference to this field of application with the sole purpose of simplifying its explanation.

### Prior art

As is well known, a testing head is essentially a device suitable for placing a plurality of contact pads of a microstructure in electrical contact with corresponding channels of a measurement machine that measures its performance, in particular electric performance, or generically performs the test.

The test performed on integrated circuits acts in particular to detect and isolate defective circuits already in the production step. Normally, testing heads are then used for the electrical test of the integrated circuits on wafers before cutting and mounting them inside a chip containment package.

A testing head essentially comprises a plurality of mobile contact elements or contact probes held by at least one pair of plates or substantially plate-shaped guides that are parallel to one another. Such guides are equipped with suitable holes and placed a certain distance apart so as to leave a free area or an air gap for the movement and possible deformation of the contact probes. The pair of guides in particular comprises an upper guide and a lower guide, both provided with guide holes in which the contact probes, normally formed from wires of special alloys with good electrical and mechanical properties, slide axially.

The good connection between the contact probes and the contact pads of the device being tested is ensured by the pressing of the testing head on the device itself, the contact probes, mobile in the guide holes made in the upper and lower guides, during such pressing contact undergoing a flexing inside the air gap between the two guides and a sliding inside such guide holes. Testing heads of this type are commonly known as vertical probes.

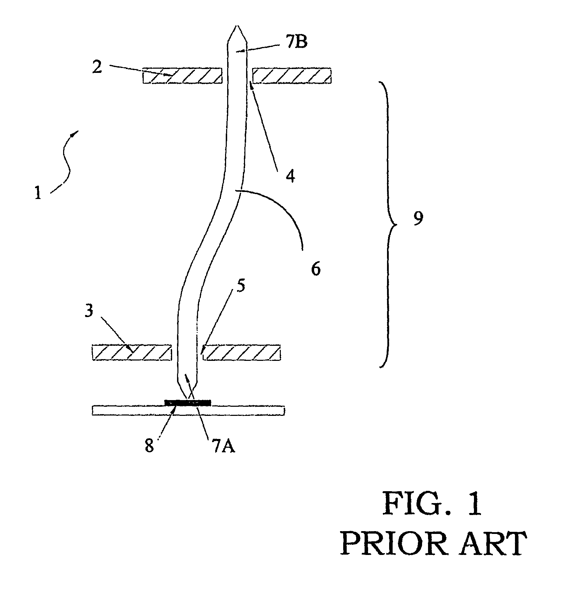

Basically, vertical probe testing heads have an air gap in which a flexing of the contact probes takes place, such flexing being able to be helped through a suitable configuration of the probes themselves or of their guides, as schematically illustrated in figure 1, where for the sake of simplicity of illustration just one contact probe of the plurality of contact probes normally included in a testing head has been represented.

In particular, figure 1 schematically illustrates a testing head 1 comprising at least one upper guide 2 and a lower guide 3, having respective upper and lower guide holes, 4 and 5 respectively, in which at least one contact probe 6 slides.

The contact probe 6 has at least one contact end or tip 7A. By the term end or tip, here and hereafter we mean an end portion, not necessarily pointed. In particular, the contact tip 7A abuts on a contact pad 8 of a device to be tested, making the mechanical and electrical contact between said device and a testing apparatus (not represented) of which such a testing head constitutes a terminal element.

In some cases, the contact probes are fixedly connected to the head itself at the upper guide: in this case they are testing heads with locked probes.

More frequently, however, testing heads are used that have probes that are not fixedly connected, but held interfaced with a so-called board through a space transformer: in this case they are testing heads with unlocked probes.

In this case, as illustrated in figure 1, the contact probe 6 has a further contact tip 7B towards a plurality of contact pads of the space transformer, not illustrated as it is conventional. The good electrical contact between probes and space transformer is ensured in an analogous way to the contact with the device to be tested through the pressing of the probes on the contact pads of the space transformer.

The upper and lower guides 2 and 3 respectively are suitably spaced from an air gap 9 that allows the deformation of the contact probes 6. Finally, the upper and lower guide holes 4 and 5 are sized so as to allow the contact probe 6 to slide inside them.

The shape of the deformation undergone by the probes and the force necessary to produce such a deformation depend upon numerous factors, such as:
- the physical characteristics of the alloy that makes up the probes;
- the value of the misalignment between guide holes in the upper guide and corresponding guide holes in the lower guide.

Moreover, it should be remembered that the correct operation of a testing head is fundamentally linked to two parameters: the vertical displacement, or overtravel, of the contact probes and the horizontal displacement, or scrub, of the contact tips of such contact probes. In particular, it is extremely important to ensure the scrub of the contact tips that allows the "cleaning" of the surface of the contact pads, improving the contact made by the testing head.

All of these characteristics should be evaluated and calibrated in the step of making a testing head, the good electrical connection between probes and device to be tested having to always be ensured.

In the case of a testing head 1 made with technology known as "shifted plate" technology, the contact probe for testing head having vertical probes 6 are made straight, with a constant circular cross section for the entire length and in general pointed at the ends to form the contact tips 7A and 7B, as illustrated in figure 1.

In order to obtain the correct operation of the contact probes 6, the upper and lower guides 2 and 3 are suitably shifted with respect to each other to allow a preferential flexing of the contact probes 6 in the same direction.

The assembly of the contact probes 6 in testing heads performed with shifted plate technology is thus very simple and fast. In particular, it is sufficient to align the upper and lower guides 2 and 3 with each other so as to also align the corresponding guide holes 4 and 5, then slot the contact probes 6 in the guide holes 4 and 5, shift the guides with respect to each other by a suitable amount then locking them in position.

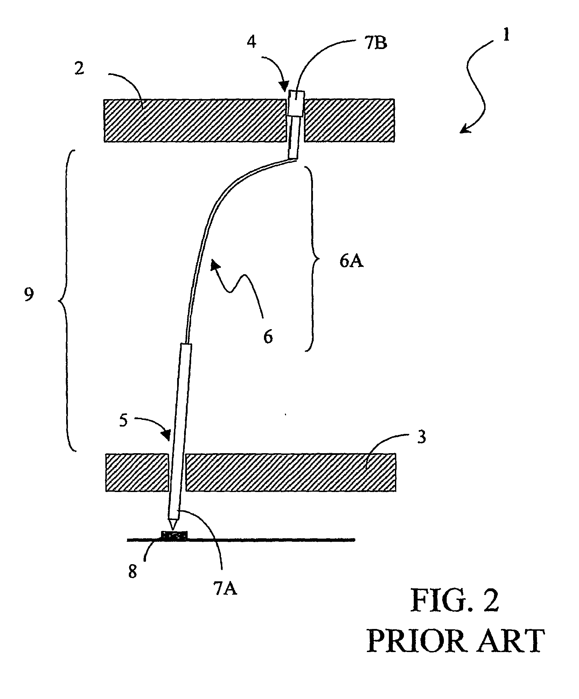

It is also known to make testing heads using technology known as Cobra schematically illustrated in figure 2, elements that are structurally and functionally identical to the testing head 1 of figure 1 having been indicated with the same reference numerals.

In this case, the contact probes 6 have a predeformed configuration with a misalignment between the contact tips 7A and 7B, the contact probe 6 comprising a predeformed portion 6A, which, even in the absence of contact of the testing head 1 with the device to be tested, helps the correct flexing of the contact probe for testing head having vertical probe during its operation, in other words when in pressing contact with such a device.

It should be noted that for a correct operation of the testing head, the contact probes must have a suitable degree of freedom of axial movement inside the guide holes. In this way, such contact probes can also be withdrawn and replaced in the case of a single probe breaking, without having to replace the entire testing head.

Such a freedom of axial movement, in particular of sliding of the probes inside the guide holes, is in contrast with the normal safety requirements of testing heads during their operation.

In particular, in the case of testing heads made with shifted plate technology, the risk of the contact probes 6 slipping out is very high during maintenance and cleaning operations of the testing head 1, operations that are normally carried out with puffs of air or ultrasound and thus create mechanical stresses on the contact probes 6, making it easier for them to slip out from the guide holes.

It should also be highlighted that there are widely used configurations in which the end portions of the contact probes, at the contact tips 7A and 7B and in particular comprising the portions of the probes that are suitable for sliding in the guide holes 4 and 5, are inclined with respect to the axes of such holes (normally perpendicular to a plane defined by the device to be tested), in order to ensure the desired scrub of the contact tips on the contact pads.

The inclination of the end portions of the contact probes with respect to the axes of the guide holes thus creates one or more contact points between probes and holes, suitable for at least partially holding the probes inside the holes.

However, it does occur that the probes, and in particular their end portions, are held excessively inside the guide holes, harming the freedom of movement of the probes themselves and influencing the correct operation of the testing head as a whole. In extreme conditions, the contact probes can "jam" inside the guide holes interrupting the entire operation of the testing head and leading to it having to be replaced.

The technical problem forming the basis of the present invention is to devise a contact probe and a related microstructure testing head capable of ensuring a correct sliding of the probe inside a relative guide hole as well as ensuring that the probes are held in position correctly inside the guides, at the same time minimising the risk of jamming of the probes and therefore the need to replace the head.

### Summary of the invention

The idea for a solution forming the basis of the present invention is to decrease the friction between the contact probes and the corresponding guide holes, in particular at their end portions.

Based upon such an idea for a solution the technical problem is solved by a contact probe of the type indicated previously and defined by the characterising part of claim 1.

Such a technical problem is also solved by a testing head defined by the characterising part of claim 14.

The characteristics and advantages of the contact probe and the testing head according to the invention shall become clearer from the following description of an example embodiment thereof, given for indicating and not limiting purposes with reference to the attached drawings.

### Brief description of the drawings

In such drawings:
Figures 1 and 2 each schematically show a testing head made according to the prior art;
Figure 3 schematically shows a testing head according to the invention;
Figures 4A and 4B schematically show a first and a second embodiment of a contact probe according to the invention;

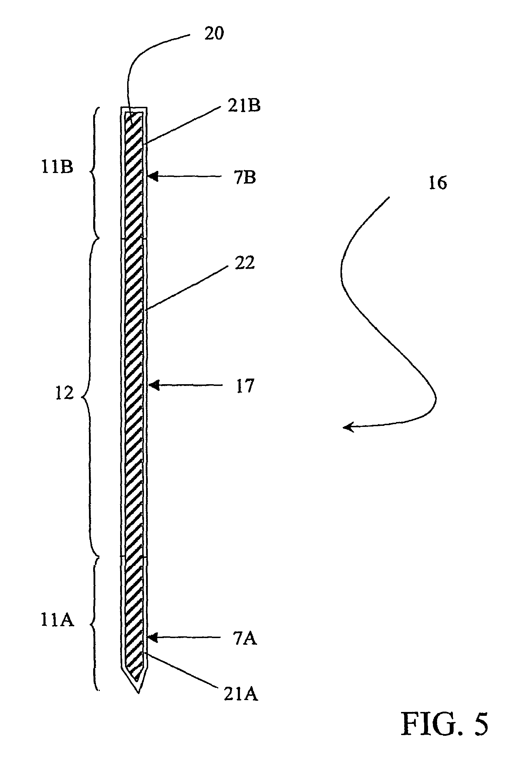

Figure 5 shows a longitudinal section of the embodiment of figure 4A; and
Figure 6 shows a longitudinal section of a contact probe according to a third embodiment of the invention.

### Detailed description

Figures 1 and 2 show a testing head made according to the prior art and already described previously.

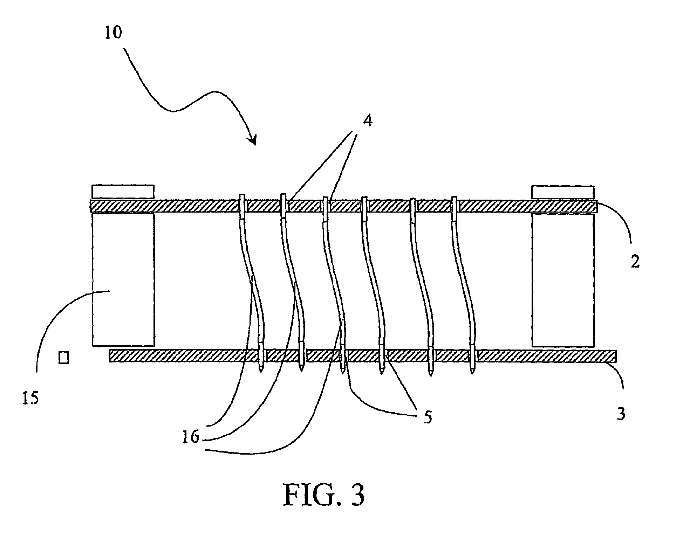

With reference to figure 3, a testing head made according to the invention is wholly indicated with 10.

In figure 3, elements that are structurally and functionally equivalent to corresponding elements of the testing heads described in relation to the prior art and illustrated in figures 1 and 2 shall be attributed the same reference numerals for the sake of simplicity of presentation.

The testing head 10 is of the type having unlocked probes and comprises an upper guide 2 and a lower guide 3, kept spaced apart by a spacer 15. Both the upper and lower guides 2 and 3 have respective upper and lower guide holes 4 and 5, in which a plurality of contact probes 16 slides.

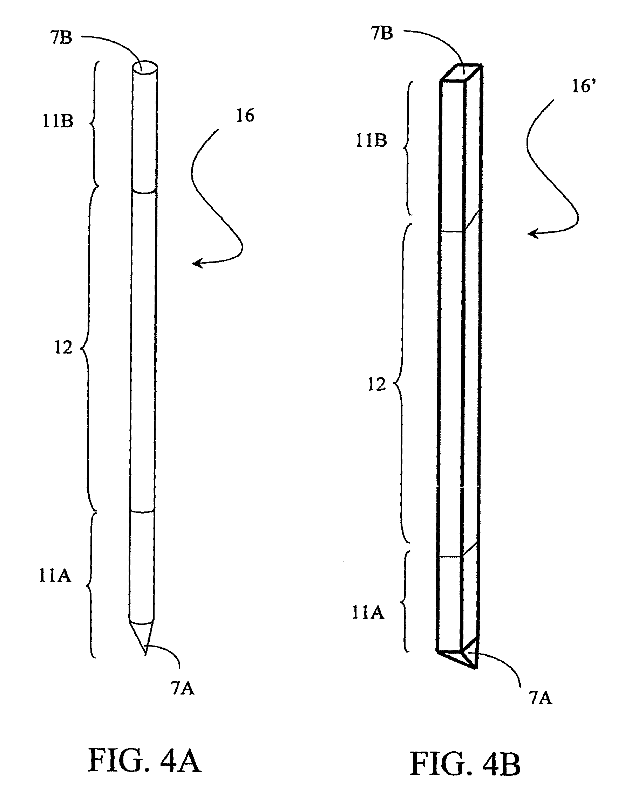

Now with reference to figure 4A, a contact probe 16 able to be used in the testing head 10 is described in greater detail, where elements that are structurally and functionally equivalent to corresponding elements of the contact probes described in relation to the prior art and illustrated in figures 1 and 2 shall be attributed the same reference numerals for the sake of simplicity of presentation.

The contact probe 16 comprises a body 20 extending essentially in the longitudinal direction and formed from a first conductive material, preferably a metal or a metallic alloy, in particular a NiMn or NiCo alloy.

The body 20 has a substantially circular cross section and has a substantially central portion 17 of predetermined length 12 and two opposite contact tips or ends, specifically a lower contact tip or end 7A and an upper contact tip or end 7B. The lower contact tip or end 7A has a predetermined length 11A and is intended to make contact pressing against a contact pad of a device to be tested (not illustrated, but in any case totally analogous to the contact pad 8 illustrated in figures 1 and 2) during the use of the contact probe 16 in the testing head 10.

The upper contact tip or end 7B has a predetermined length and, on the other hand, is intended to make contact pressing against a space transformer (not illustrated), during the use of the contact probe 16 in the testing head 10, the latter indeed being of the type having unlocked probes.

In accordance with the present invention, the ends 7A and 7B respectively of the body 20 of the contact probe 16 are each coated with a layer 21A and 21B respectively of a second conductive material having greater hardness than said first conductive material. Preferably, the second conductive material of the coating layers 21A and 21B is a metal or a metallic alloy, in particular rhodium, gold, platinum or a PdCo alloy.

Advantageously, such a second conductive material has good electrical conductivity and therefore it does not significantly deteriorate the values measured by the contact probe.

Preferably, the layers 21A and 21B of the second conductive material each have a thickness of between 0.01 microns and 5 microns. In the embodiment illustrated in figures 4A and 4B, the layers 21A and 21B each have a thickness of about 1 micron. It should be noted that the use of coating layers of low thickness like the layers 21A and 21B avoids breakages that could otherwise occur if the ends 7A and 7B were made harder through coating with layers of greater thickness, or even if the ends 7A and 7B were made entirely from the second conductive material.

The layers 21A and 21B each extend at an end portion of the respective end extending up to the height of the guide holes 4, 5, in particular extending from the respective contact tip up to the entire height of such guide holes 4, 5. However, in accordance with alternative embodiments, such layers 21A and 21B could also be partial, and arranged at just the height of the guide holes 4, 5, in particular extending for a height equivalent to that of the guide holes 4, 5.

In the contact probe 16 according to the invention, the central portion 17 of the central body 20 is also coated with a layer 22 of insulating material, in this specific case parylene.

Advantageously, the parylene coating 22 of the central portion 17 of each contact probe 16 improves the electrical insulation of the probes, in particular avoiding short-circuits in the case of accidental contact between adjacent contact probes 16.

In the assembly step, each contact probe 16 is slotted into the guide holes 4 and 5 of the respective guides 2 and 3 of the testing head 10 and the guides 2 and 3 are shifted so as to cause the deformation of the probes 16 that are therefore locked in position with the ends 7A and 7B that can nevertheless slide in the guide holes 4 and 5 for at least a portion thereof.

In the use step, each of the ends 7A of the plurality of probes 16 included in the testing head 10 is slotted inside the respective guide hole 5, and in contact with the contact pad of the device to be tested. Such an end 7A is thus able to carry out the scrub of the respective pad.

Equally, each of the ends 7B is slotted inside the respective guide hole 4 and in contact with a respective contact pad of the space transformer. Such an end 7B is thus equally able to carry out the scrub of the respective pad of the space transformer.

During operation, each contact probe 16 is subject to displacements with its ends 7A and 7B in the respective guide holes 4 and 5; in particular, the ends 7A and 7B respectively can make contact with the walls of the guide hole 5 and 4, respectively. Advantageously according to the invention, it is the layers of the second conductive material 21A and 21B respectively, harder than the first conductive material, that come into contact with the walls of the guide hole 5 and 4, respectively. The hardness of the second conductive material advantageously allows the reduction of friction between such ends 7A and 7B and the walls of the guide holes 5 and 4 to be decreased; thus, the wear of the contact probe 16 is able to be decreased at its ends 7A and 7B.

In general, therefore, the use of the second conductive material as coating material of at least the end portions of the contact probes 16 allows the sliding thereof in the respective guide holes to be improved.

Now with reference to figure 4B, a contact probe according to another embodiment of the invention, able to be used in the testing head 10 is globally indicated with number 16'.

The contact probe 16', illustrated in figure 4B, has the same elements as the contact probe 16 described above, which are attributed the same reference numerals. However, the contact probe 16' differs from the contact probe 16 described above in that it has a polygonal cross section, in particular a substantially rectangular section. In this case, the guide holes must also have a polygonal cross section, in particular rectangular.

Advantageously, the use of the probes 16' with polygonal cross section allows its correct positioning with respect to the contact pads. Moreover, it can easily be seen that the compression of such contact probes 16' is particularly controlled, the deformation taking place in a predetermined plane and the polygonal section of the guide holes not allowing a rotation of the contact probe 16' inserted in it.

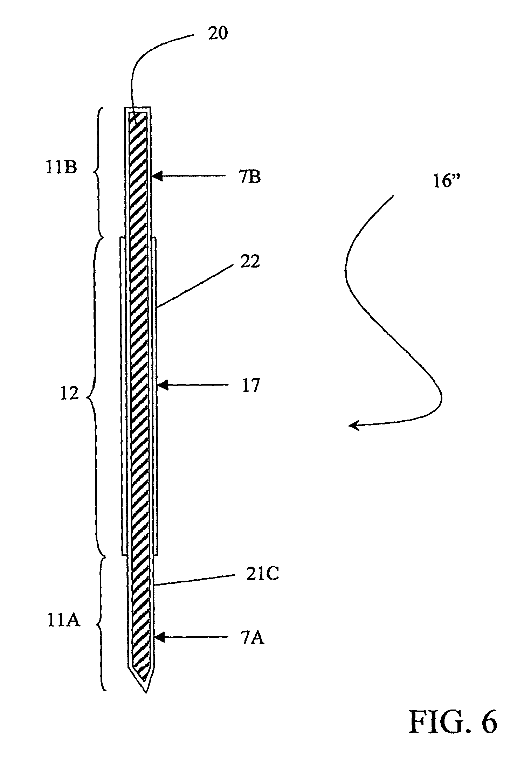

Now with reference to figure 6, a contact probe according to a further embodiment of the invention is globally indicated with number 16".

Elements of the contact probe 16", illustrated in figure 6, that are structurally identical or equivalent to corresponding elements of the contact probe described above shall be attributed the same reference numerals.

The contact probe 16" differs from the probe 16 described above in that the entire body 20 of the probe (thus including the central portion 17, the upper end 7B and the lower end 7A) is coated with a layer 21C of second conductive material (for example rhodium) having greater hardness than the material (first conductive material) constituting the body (20) of the probe 16".

A layer 22 of insulating material, preferably parylene, is also foreseen on the layer 21C of the second conductive material at the central portion 17, said layer 22 of insulating material extending substantially along the entire longitudinal extension (length 12) of the central portion 17.

Such an embodiment allows a greater hardness of the contact probe to be obtained, ensuring the electrical insulation of the probe itself even in the case of accidental contact with other adjacent contact probes.

The contact probe according to the invention can be produced through method that comprises the steps of:
- providing a probe made from a first conductive material comprising a body with longitudinal extension having a central portion and two opposite ends, and
- at least partially coating at least one of said opposite ends with a layer of a second conductive material having greater hardness than said first conductive layer.

The method according to the invention also comprises a step of coating the central portion with a layer of insulating material.

Preferably, the at least partial coating of at least one of said opposite ends is carried out through electrodeposition of said second conductive material on said at least one of the opposite ends.

Preferably the step of coating the central portion with a layer of insulating material in carried out before the step of at least partially coating at least one of said opposite ends with a layer of a second material. In this way, the layer of insulating material advantageously acts as an electrodeposition mask for the central body with it promoting just the coating of one or both of the ends of the contact probe.

Of course, a man skilled in the art can bring modifications and variants o the contact probe described above, according to contingent and specific requirements, moreover without departing from the scope of protection of the claims. For example, the coating of the ends 7A and 7B of the contact probe 16, 16' or 16" could foresee a plurality of layers of a second conductive material, the conductive material of said layers being able to be the same or different.

## Claims

1. Contact probe (16, 16', 16") for testing head having vertical probes for testing microstructure performance, in particular electric performance, said contact probe (16, 16', 16") comprising a body (20) extending essentially in the longitudinal direction formed in a first conductive material, said body (20) having a substantially central portion (17) and two opposite ends (7A, 7B), said contact probe (16) being able to be held so that it can slide through said opposite ends (7A, 7B) between corresponding guide holes (4, 5) made in an upper guide (2) and in a lower guide (3) of said testing head, **characterised in that** at least one of said ends (7A, 7B) is at least partially coated with a layer (21A, 21B; 21 C) of a second conductive material having a greater hardness than said first conductive material so as to improve the sliding of said at least one end (7A, 7B) in the respective guide hole (5, 4).

2. Contact probe according to claim 1, **characterised in that** both the ends (7A, 7B) of said contact probe (16) are at least partially coated with a layer (21A, 21B) of said second conductive material.

3. Contact probe according to claim 2, **characterised in that** said ends (7A, 7B) are coated with a layer of said second metallic material at an end portion thereof extending up to the height of said corresponding guide holes (5, 4).

4. Contact probe according to any one of the previous claims, **characterised in that** said ends (7A, 7B) of said contact probe (16) are completely coated with a respective layer (21A, 21B) of said second conductive material.

5. Contact probe according to any one of the previous claims, **characterised in that** said first conductive material is a metal or a metallic alloy.

6. Contact probe according to claim 5, **characterised in that** said first conductive material is a NiMn alloy or a NiCo alloy.

7. Contact probe according to any one of the previous claims, **characterised in that** said second conductive material is a metal or a metallic alloy.

8. Contact probe according to claim 7, **characterised in that** said metal is selected from gold, rhodium and platinum.

9. Contact probe according to claim 7, **characterised in that** said metallic alloy is a PdCo alloy.

10. Contact probe according to any one of the previous claims, **characterised in that** said layer of a second metallic material has a thickness of between 0.01 microns and 5 microns.

11. Contact probe according to any one of the previous claims, **characterised in that** said substantially central portion (17) is coated with a layer (22) of insulating material.

12. Contact probe according to any one of claims 1 to 10, **characterised in that** said body (20) extending essentially in the longitudinal direction is entirely coated with a layer (21 C) of second conductive material.

13. Contact probe according to claim 12, **characterised in that** it comprises a layer (22) of insulating material arranged on the layer (21 C) of the second conductive material at said central portion (17), said layer (22) of insulating material extending substantially along the entire longitudinal extension of the central portion (17).

14. Contact probe according to any one of claims 11 to 13, **characterised in that** said insulating material is parylene.

15. Testing head having vertical probes for testing microstructure performance, in particular electric performance, said testing head comprising a plurality of guide holes (4, 5) corresponding to a plurality of contact probes, such guide holes (4, 5) being made in an upper guide (2) and in a lower guide (3) of said testing head, **characterised in that** it comprises a plurality of contact probes (16) according to any one of the previous claims.

16. Testing head according to claim 15, **characterised in that** it is of the shifted plate type.

17. Process for producing a contact probe (16, 16', 16") according to any one of the previous claims, comprising the steps of:
- providing a probe (16, 16', 16") made from a first conductive material comprising a body (20) with longitudinal extension having a central portion (17) and two opposite ends (7A, 7B), and
- at least partially coating at least one of said opposite ends (7A, 7B) with a layer (21A, 21B; 21C) of a second conductive material having greater hardness than said first conductive layer.

18. Process according to claim 17, **characterised in that** it also comprises a step of coating said central portion (17) with a layer of insulating material (22).

19. Process according to claim 18, **characterised in that** said at least partial coating of at least one of said opposite ends (7A, 7B) is carried out through electrodeposition of said second metallic material on said at least one of the opposite ends (7A, 7B).

20. Process according to claim 19, **characterised in that** said electrodeposition of said second metallic material uses said insulating material (22) as a mask.
